(19) Europäisches Patentamt
European Patent Office
Office européen des brevets

(11) Veröffentlichungsnummer : **0 048 220**
**B1**

(12) **EUROPÄISCHE PATENTSCHRIFT**

(45) Veröffentlichungstag der Patentschrift : **22.10.86**

(21) Anmeldenummer : **81810371.5**

(22) Anmeldetag : **09.09.81**

(51) Int. Cl.⁴ : **H 05 K 1/05**, C 08 G 73/10, C 08 G 69/48, C 08 G 69/42

(54) **Verwendung von flexiblem Basismaterial zur Herstellung von gedruckten Schaltungen.**

(30) Priorität : **15.09.80 CH 6905/80**

(43) Veröffentlichungstag der Anmeldung : **24.03.82 Patentblatt 82/12**

(45) Bekanntmachung des Hinweises auf die Patenterteilung : **22.10.86 Patentblatt 86/43**

(84) Benannte Vertragsstaaten : **AT CH DE FR GB IT LI NL**

(56) Entgegenhaltungen :
**DE-A- 2 426 885**
**GB-A- 2 003 899**
**US-A- 3 809 591**
**CHEMICAL ABSTRACTS, Band 86, Nr. 22, 30. Mai 1977, Seite 94, Nr. 157218a, Columbus, Ohio, USA**
**Hochtemperatur beständige Kunststoffe, Karl Hansen Verlag München 1969**

(73) Patentinhaber : **CIBA-GEIGY AG**
**Klybeckstrasse 141**
**CH-4002 Basel (CH)**

(72) Erfinder : **Darms, Roland, Dr.**
**Kleinfeldweg 3**
**CH-4106 Therwil (CH)**
Erfinder : **Beyeler, Harry**
**Magnolienpark 18**
**CH-4052 Basel (CH)**
Erfinder : **Haug, Theobald, Dr.**
**Untere Flühackerstrasse 12**
**CH-4402 Frenkendorf (CH)**

EP 0 048 220 B1

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die vorliegende Erfindung betrifft die Verwendung von flexiblen Basismaterialien aus mit siloxangruppenhaltigen Polyamiden, Polyimiden und Polyamid-imiden beschichteten Metallfolien zur Herstellung von flexiblen gedruckten Schaltungen.

Flexible gedruckte Schaltungen bieten gegenüber den starren gedruckten Schaltungen bekanntlich viele technische Vorteile. Sie lassen sich besser handhaben, da sie praktisch in jeder Form als elektronisches Bauelement in das System eingefügt werden können, benötigen dadurch weniger Platz im elektrischen Gerät und sind auch unempfindlicher gegenüber Vibrationen.

An das flexible Basismaterial, die mit einem Isolierstoff beschichtete Metallfolie, welche zur Herstellung von gedruckten Schaltungen verwendet wird, werden allerdings hohe Anforderungen gestellt. Die Beschichtung muss eine sehr gute Haftung auf der Metallfolie aufweisen, und die Arbeitsprozesse bei der Herstellung von gedruckten Schaltungen schadlos überstehen, das heisst, die Beschichtung muss eine gute Lötbadbeständigkeit aufweisen sowie eine gute Beständigkeit gegenüber den in der Leiterplattentechnologie eingesetzten Lösungsmitteln. Das flexible Basismaterial muss ferner gebogen, gerollt, verdreht und gefaltet werden können, ohne dass es bei der Beschichtung zur Rissbildung oder Abkantung kommt.

Mit Polyimidfolien beschichtete Metallfolien, die durch Aufkaschieren einer Polyimidfolie auf eine mit einem Bindemittel versehenen Kupferfolie erhalten werden, erfüllen diese Anforderungen nich in jeder Hinsicht ; insbesondere lassen die elektrischen Eigenschaften zu wünschen übrig. Die Eigenschaften solcher Laminate werden von dem verwendeten Bindemittel und dem Klebevorgang mitbestimmt.

Aus US-A-3 682 960 ist ferner bekannt, Metalle mit einer Mischung aus einer Polyamidsäure und einer mit Amiden modifizierten Polyamidsäure zu beschichten. Die nach Erhitzen auf den Metallen erhaltenen Beschichtungen aus Polyimiden und Polyamidimiden weisen aber den Nachteil auf, dass sie nicht genügend flexibel sind und leicht von der Metallfolie abkanten.

Um diese Nachteile zu umgehen, wird deshalb in US-A-4 148 969 vorgeschlagen, Laminate aus mit Polyparabansäuren beschichteten Metallfolien zu verwenden, wobei die verwendete Polyparabansäure durch Hydrolyse des Reaktionsproduktes von Diphenylmethandiisocyanat mit Cyanwasserstoff hergestellt wird. Abgesehen davon, dass die Herstellung von der verwendeten Polyparabansäure kompliziert ist, muss man in der Vorstufe mit Cyanwasserstoff arbeiten, wobei zusätzliche Vorsichtsmassnahmen getroffen werden müssen.

Es wurde nun gefunden, dass man auf eine einfachere Art flexible gedruckte Schaltungen erhält, wenn man flexible Basismaterialien aus auf Metallfolien ohne Zwischenschicht fest haftenden Polymerfolien verwendet, die erhalten werden, indem man die Metallfolie mit einer organischen Lösung eines siliciummodifizierten Polyamid-, Polyamidsäure- oder Polyamid-amidsäure-Präpolymeren beschichtet und die Beschichtung in der Wärme unter Verdampfung des organischen Lösungsmittels härtet.

Gegenstand der vorliegenden Erfindung ist somit die Verwendung von flexiblen Basismaterial zur Herstellung von flexiblen gedruckten Schaltungen, wobei das Basismaterial aus einer ohne Zwischenschicht mit einem Polymeren beschichteten Metallfolie besteht und dadurch gekennzeichnet ist, dass die Polymer-Beschichtung aus einem vernetzten siloxangruppenhaltigen Polyamid, Polyimid oder Polyamidimid mit einem Siliciumgehalt von 0,1 bis 2,0 Gew.-% besteht und erhalten wird, indem man siliciummodifizierte Polyamid-, Polyamidsäure- oder Polyamid-amidsäure-Präpolymere mit einer inhärenten Viskosität von 0,3 bis 4,0 der Formel I

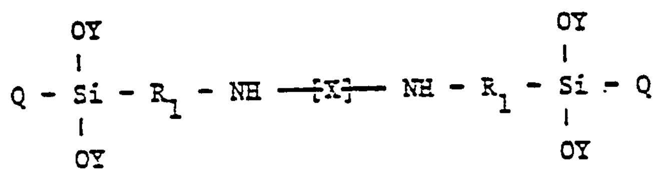

(I)

worin X ein Strukturelement der Formel II

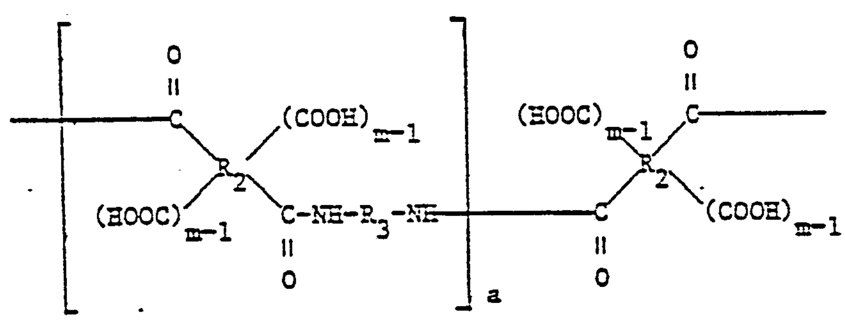

(II)

darstellt,

a eine Zahl von 15 bis 100 bedeutet und die einzelnen m, $R_1$, $R_2$, $R_3$, Q und Y unabhängig voneinander das folgende bedeuten :

m die Zahl 1 oder 2,

$R_1$ einen Rest

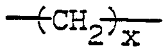 , 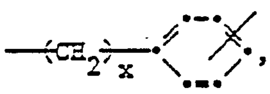 , 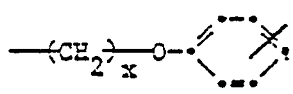 oder

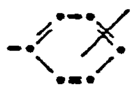 ,

wobei x eine Zahl von 1 bis 4 bedeutet,

$R_2$ einen carbocyclisch-aromatischen oder heterocyclischen Rest, wobei die Carbonamid- und Carboxylgruppen an verschiedene Ringkohlenstoffatome gebunden sind und sich die Carboxylgruppen je in ortho-Stellung zu einer Carbonamidgruppe befinden,

$R_3$ einen carbocyclisch-aromatischen oder heterocyclischen Rest,

Q Methyl, Phenyl oder einen Rest —OY und

Y einen Alkylrest mit 1 bis 6 Kohlenstoffatomen oder einen Phenylrest, auf Temperaturen zwischen 50 und 350 °C erhitzt.

Vorzugsweise enthält das erfindungsgemäss verwendete Basismaterial als Metallfolie eine Kupferfolie.

Die auf der Metallfolie fest haftende Beschichtung besteht vorzugsweise aus einen vernetzten siloxangruppenhaltigen Polyamid, Polyimid oder Polyamid-imid und wird erhalten, indem man siliciummodifizierte Präpolymere der Formel I, worin a für eine Zahl von 50 bis 100 steht und m, $R_1$, $R_2$, $R_3$, Q und Y die gleiche Bedeutung wie in Formel I haben, auf Temperaturen zwischen 50 und 350 °C erhitzt.

Insbesondere bestehen die Beschichtungen aus vernetzten siloxangruppenhaltigen Polyamiden, Polyimiden oder Polyamid-imiden, die aus den Präpolymeren der Formel I, worin die einzelnen $R_2$ unabhängig voneinander einen unsubstituierten monocyclischen, kondensierten polycyclischen oder unkondensierten bicyclischen aromatischen Rest darstellen, wobei bei letzterem die Aromatenkerne über das Brückenglied —O— oder —CO— miteinander verbunden sind, die einzelnen $R_3$ unabhängig voneinander einen unsubstituierten monocyclischen oder bicyclischen aromatischen Rest darstellen, wobei bei letzterem die Aromatenkerne über das Brückenglied —O—, $—CH_2—$, $—C(CH_3)_2—$, $—SO_2—$ oder durch eine direkte Bindung miteinander verbunden sind und m, $R_1$, Q und Y die gleiche Bedeutung wie in Formel I haben, durch Erhitzen auf Temperaturen zwischen 50° und 350° erhalten werden.

In einer besonderen Ausführungsform verwendet man Basismaterial, das eine Beschichtung aus einem Polyimid aufweist, das durch Erhitzen eines siliciummodifizierten Präpolymeren der Formel I, worin m für die Zahl 2 steht, $R_2$ einen Benzolring oder das Benzophenonringsystem und $R_3$ den 4,4'-Diphenyläther- oder 4,4'-Diphenylmethanrest darstellen und $R_1$, Q und Y die gleiche Bedeutung wie in Formel I haben, erhalten wird.

Die erfindungsgemässe verwendeten flexiblen Basismaterialien werden erhalten, indem man eine Metallfolie, vorzugsweise eine Cu-Folie, mit einer organischen Lösung eines siliciummodifizierten Polyamid-, Polyamidsäure- oder Polyamid-amidsäure-Präpolymeren mit einer inhärenten Viskosität von 0,3 bis 4,0 der Formel I beschichtet und die beschichtete Metallfolie unter Verdampfung des organischen Lösungsmittels auf Temperaturen zwischen 50 und 350 °C erhitzt.

Die zur Beschichtung der Metallfolien verwendeten siliciummodifizierten Polyamid-, Polyamidsäure- und Polyamid-amidsäure-Präpolymeren sind aus der DE-A-2 426 885 bekannt und können nach den dort beschriebenen Verfahren hergestellt werden, indem man beispielsweise der Formel II entsprechende Polyamide oder Polyamid-amidsäuren mit 2 Anhydridendgruppen oder Polyamid-amidsäuren mit einer Säurechlorid- und einer Anhydridendgruppe mit mindestens 2 Mol eines Aminosilans der Formel III

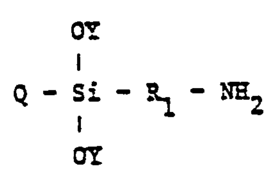 (III)

umsetzt, wobei für a, m, $R_1$, $R_2$, $R_3$, Q und Y die gleiche Bedeutung wie unter Formel I haben.

Aus der genannten DE-A geht ferner hervor, dass sich die siloxangruppenhaltigen Polyamid, Polyamidsäure- und Polyamid-amidsäure-Präpolymeren zum Beschichten oder Verkleben von Substraten der verschiedensten Art, wie Metalle, Polymere oder Cellulosematerialien, eignen, doch lässt sich kein

Hinweis entnehmen, dass sich die mit den Präpolymeren beschichteten Metallfolien äusserst flexibel verhalten, das heisst, ein wiederholtes Biegen und Falten ohne Rissbildung im Polymerfilm überstehen und ausserdem eine gute Lötbadbeständigkeit sowie eine gute Beständigkeit gegenüber den in der Leiterplattentechnologie eingesetzten Lösungsmitteln aufweisen.

Die verwendeten siliciummodifizierte Polyamid-, Polyamidsäure- und Polyamid-amidsäure-Präpolymere weisen bevorzugt eine inhärente Viskosität von 0,5 bis 2,5 auf.

Die inhärente Viskosität $\eta_{inh.}$, die ein Mass für das Molekulargewicht eines Polymeren darstellt, berechnet sich nach folgender Gleichung :

$$\eta_{inh.} = \frac{\ln \frac{\eta}{\eta_0}}{c}$$

worin

ln = natürlicher Logarithmus,

$\eta$ = Viskosität der Lösung (0,5 Gew.% des Polymeren in einem geeigneten Lösungsmittel, z. B. N,N-Dimethylacetamid, N,N-Dimethylformamid, N-Methylpyrrolidon),

$\eta_0$ = Viskosität des Lösungsmittels und

c = Konzentration der Polymerlösung in g Polymer/100 ml Lösungsmittel

bedeuten.

Die Viskositätsmessungen erfolgen bei 25 °C. Wie allgemein bekannt ist, stellt die inhärente Viskosität ein Mass für das Molekulargewicht eines Polymeren dar. Die angeführten Werte von $\eta_{inh.}$ = 0,3 bis 4,0 entsprechen der mittleren Molekulargewichten von etwa 4 000 bis 50 000. Die mittleren Molekulargewichte können nach an sich bekannten Methoden, z. B. mittels Lichtstreuung, bestimmt werden.

Bei den Präpolymeren mit Strukturelementen X der Formel II, worin die einzelnen m, $R_2$ und/oder $R_3$ unterschiedliche Bedeutung haben können, kann es sich um Homopolymere oder um Copolymere mit statistischer Verteilung oder mit beliebiger, mindestens teilweise blockartiger Anordnung der Polyamid-, Polyamidsäure- und/oder Polyamid-amidsäure-Einheiten im Strukturelement X handeln.

Die siliciummodifizierten Präpolymeren, die vorzugsweise in einem wasserfreien organischen Lösungsmittel und unter Feuchtigkeitsausschluss hergestellt werden, werden vorteilhaft in Form dieser organischen Lösungen verarbeitet. Geeignete organische Lösungsmittel sind : N,N-Dimethylacetamid, N,N-Diäthylacetamid, N,N-Dimethylformamid, N,N-Dimethylmethoxyacetamid, N-Methyl-2-pyrrolidon, N-Acetyl-2-pyrrolidon, N-Methyl-ε-caprolactam, Hexamethylphosphorsäuretriamid (Hexametapol), N,N,N',N'-Tetramethylharnstoff, Tetrahydrothiophendioxid (Sulfolan) und Dimethylsulfoxid.

Es können auch Gemische solcher Lösungsmittel verwendet werden. Andererseits ist es auch möglich, diese bevorzugten Lösungsmittelsysteme mit anderen organischen aprotischen Lösungsmitteln, wie aromatischen, cycloaliphatischen oder aliphatischen, gegebenenfalls chlorierten Kohlenwasserstoffen, beispielsweise Benzol, Toluol, Xylolen, Cyclohexan, Pentan, Hexan, Petroläther, Methylenchlorid, Tetrahydrofuran, Cyclohexanon und Dioxan, zu verdünnen.

Um die Lagerstabilität der organischen Lösung der siliciummodifizierten Präpolymeren zu erhöhen, ist es zweckmässig, der Lösung eine wasserabsorbierende Substanz, wie zum Beispiel ein Molekularsieb, zuzugeben. Molekularsiebe werden vorteilhaft in Mengen von etwa 10 Gewichtsprozent, bezogen auf die Menge der organischen Lösung, zugesetzt. Molekularsiebe sind im Handel erhältlich, zum Beispiel als Handelsprodukte der Firma Merck.

Ueberraschenderweise wurde weiterhin gefunden, dass es vorteilhaft ist, den organischen Lösungen der siliciummodifizierten Präpolymeren vor der Verarbeitung ein Fliessmittel, zum Beispiel « Modaflow » (Handelsprodukt der Firma Monsanto), zuzugeben.

Die Beschichtung der Metallfolien mit den organischen Polymer-Lösungen kann sowohl von Hand als auch mit Beschichtungsmaschinen vorgenommen werden. Es können auch vertikale Beschichtungsmaschinen eingesetzt werden. Bei der maschinellen Beschichtung ist es lediglich wichtig, dass eine klebfreie Beschichtung auf der Metallfolie erhalten wird, sodass dieser Schichtstoff sich gewünschtenfalls aufrollen lässt. Zur Erzielung optimaler Eigenschaften kann dieser Schichtstoff nachträglich auf höhere Temperaturen, zum Beispiel 4 Stunden auf 180 °C und 2 Stunden auf 250 °C, erhitzt werden, wobei praktisch eine vollständige Cyclisierung und Vernetzung der Polyamidsäure- und Polyamid-amidsäure-Präpolymeren zu den entsprechenden Polyimiden und Polyamid-imiden eintritt.

Die auf diese Weise beschichteten Metallfolien können direkt zur Herstellung von gedruckten Schaltungen verwendet werden, indem man die auf der Metallseite mit einem Photolack versehene Folie durch eine Photomaske belichtet und die belichtete Metallfolie in bekannter Weise entwickelt. Dabei werden flexible, gedruckte Schaltungen mit hoher mechanischer Festigkeit erhalten.

Beispiel 1

A. Herstellung eines siliciummodifizierten Polyamidsäure-Präpolymeren

In einem Sulfierkolben, der mit Rührer, Innenthermometer, Tropftrichter, Gaseinleitungsrohr und

Druckausgleichgefäss ausgestattet ist, werden unter Stickstoff 13,741 g (0,063 0 Mol) Pyromellitsäuredianhydrid in 60 g wasserfreiem N,N-Dimethylacetamid unter Rühren suspendiert. Die Suspension wird unter Rühren auf 10 °C abgekühlt. Dann werden 12,133 g (0,060 Mol) 4,4'-Diaminodiphenylmethan in 50 g wasserfreiem N,N-Dimethylacetamid bei 45 °C unter Rühren klar gelöst. Die Lösung wird auf 10 °C abgekühlt und bei 10 °C während 1 Stunde zur Suspension zugetropft, wobei der Pyromellitsäuredianhydrid langsam in Lösung geht. Das Reaktionsgemisch wird deutlich viskos, klar und hell-gelb. Dann lässt man das Reaktionsgemisch bei 10-15 °C während 30 Minuten ausreagieren. Anschliessend werden 1,327 g (0,006 Mol) γ-Aminopropyltriäthoxysilan, gelöst in 15 g wasserfreiem N,N-Dimethylacetamid, unter Rühren bei 10-15 °C während 30 Minuten zur viskosen Mischung zugetropft. Danach lässt man das Reaktionsgemisch noch 30 Minuten bei Raumtemperatur ausreagieren. Man erhält eine klare, hell-gelbe, viskose Lösung eines Polyamidsäure-Präpolymeren mit endständigen Triäthoxysilylgruppen einer inhärenten Viskostität von 1,1 dl/g (c = 0,5 % in N,N-Dimethylacetamid), die direkt zum Beschichten von Cu-Folien verwendet werden kann.

B. Herstellung einer beschichteten Kupferfolie

Die Lösung des obigen Präpolymeren wird gleichmässig mit einer Rakel auf Cu-Folien verteilt und bei 70°-150°/20 mbar während 7 Stunden vorgetrocknet und dabei vom Lösungsmittel befreit. Anschliessend werden die Laminate bei 200-250 °C/0,10 mbar während 10 Stunden einer thermischen Behandlung unterzogen. Man erhält gut haftende, flexible, transparente Ueberzüge mit glatter Oberfläche auf der Cu-Folie. Die beschichteten Cu-Folien haben ausgezeichnete elektrische Eigenschaften.

Stabilität der beschichteten Cu-Folien in chlorierten Kohlenwasserstoffen bei Raumtemperatur

| | 7 Tage | 14 Tage | 30 Tage | 60 Tage |
|---|---|---|---|---|
| Chloroform | i.O. * | i.O. | i.O. | i.O. |
| Chlorbenzol | " | " | " | " |
| Tetrachlorkohlenstoff | " | " | " | " |
| Dichlormethan | " | " | " | " |
| Aethylenchlorid | " | " | " | " |
| 1,1,1-Trichlormethan | " | " | " | " |

* i. O. = in Ordnung (kein Angriff)

Aetzversuch im $FeCl_3$-Bad

In einem Eisen-III-chloridbad (30 %-ige wässrige Lösung) werden die beschichteten Cu-Folien eingelegt und mittels leichter Luftdurchströmung das $FeCl_3$-Bad in Bewegung gehalten. Nach dem Wegätzen des Kupfers sind die Folien noch flexibel.

Beispiel 2

A. Herstellung eines siliciummodifizierten Polyamidsäure-Präpolymeren

In einem Sulfierkolben, versehen mit Rührer, Innenthermometer, Tropftrichter, Gaseinleitungsrohr und Druckausgleichsgefäss, werden unter Stickstoff 65,44 g (0,300 Mol) Pyromellitsäuredianhydrid in 350 g wasserfreiem N,N-Dimethylacetamid unter Rühren suspendiert. Die Suspension wird unter Rühren auf — 15 °C abgekühlt. Dann werden 59,070 g (0,295 Mol) 4,4'-Diaminodiphenyläther in 300 g wasserfreiem N,N-Dimethylacetamid unter Rühren klar gelöst. Diese Lösung wird bei — 15 °C bis — 10 °C während 1 Stunde zur Suspension zugetropft, wobei der Pyromellitsäuredianhydrid langsam in Lösung geht. Das Reaktionsgemisch wird deutlich viskos, klar und gelblich. Dann wird noch 30 Minuten bei 0-5 °C ausreagieren gelassen. Anschliessend werden 2,212 g (0,100 Mol) γ-Aminopropyltriäthoxisilan in 65 g wasserfreiem N,N-Dimethylacetamid gelöst. Diese Lösung wird unter Rühren innerhalb von 30 Minuten zur viskosen Lösung zugetropft. Danach lässt man das Reaktionsgemisch bei 0° bis 5 °C 30 Minuten ausreagieren. Man erhält eine klare viskose, gelbliche Lösung eines Polyamidsäure-Präpolymeren mit endständigen Triäthoxysilylgruppen mit einer inhärenten Viskosität von 1,2 dl/g (c = 0,5 % in N,N-Dimethylacetamid), die direkt zum Beschichten von Cu-Folien verwendet werden kann.

B. Herstellung einer beschichteten Kupferfolie

Die Lösung des obigen Präpolymeren wird gleichmässig mit einer Rakel auf Cü-Folien verteilt und bei 70°-150 °C/20 mbar während 7 Stunden vorgetrocknet und dabei vom Lösungsmittel befreit. Anschliessend werden die Laminate bei 200°-250 °C/0,10 mbar während 10 Stunden einer thermischen Behandlung unterzogen. Man erhält gut haftende, flexible, transparente Ueberzüge mit glatter Oberfläche auf der Cu-Folie. Die beschichteten Cu-Folien haben ausgezeichnete elektrische Eigenschaften.

Stabilität der beschichteten Cu-Folien in chlorierten Kohlenwasserstoffen bei Raumtemperatur

| | 7 Tage | 14 Tage | 30 Tage | 60 Tage |
|---|---|---|---|---|
| Chloroform | i.O. * | i.O. | i.O. | i.O. |
| Chlorbenzol | " | " | " | " |
| Tetrachlorkohlenstoff | " | " | " | " |
| Dichlormethan | " | " | " | " |
| Aethylenchlorid | " | " | " | " |
| 1,1,1-Trichlormethan | " | " | " | " |

* i. O. = in Ordnung (kein Angriff)

Aetzversuch im $FeCl_3$-Bad

In einem Eisen-III-chloridbad (30 %-ige wässrige Lösung) werden die beschichteten Cu-Folien eingelegt und unter leichter Luftdurchströmung das $FeCl_3$-Bad in Bewegung gehalten. Nach dem Wegätzen des Kupfers sind die Folien noch flexibel.

## Patentansprüche

1. Verwendung von flexiblem Basismaterial zur Herstellung von flexiblen gedruckten Schaltungen, wobei das Basismaterial aus einer ohne Zwischenschicht mit einem Polymeren beschichteten Metallfolie besteht, dadurch gekennzeichnet, dass die Polymer-Beschichtung aus einem vernetzten siloxangruppenhaltigen Polyamid, Polyimid oder Polyamid-imid mit einem Siliciumgehalt von 0,1 bis 2,0 Gew.-% besteht und erhalten wird, indem man siliciummodifizierte Polyamid-, Polyamidsäure- oder Polyamidamidsäure-Präpolymere mit einer inhärenten Viskosität von 0,3 bis 4,0 der Formel I

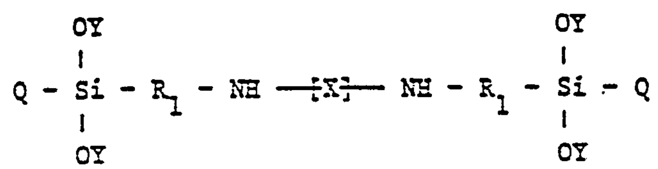

(I)

worin X ein Strukturelement der Formel II

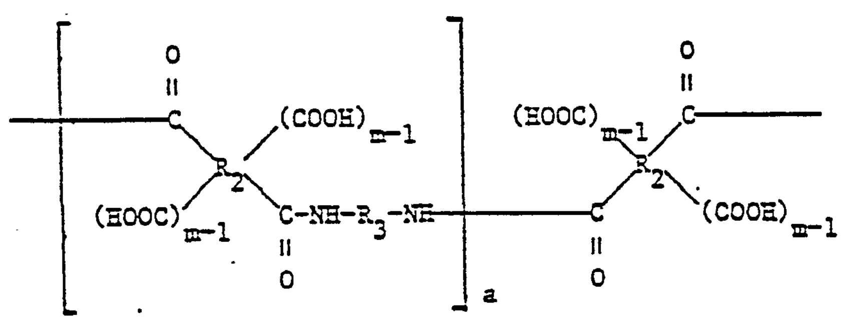

(II)

darstellt,

a eine Zahl von 15 bis 100 bedeutet und die einzelnen m, $R_1$, $R_2$, $R_3$, Q und Y unabhängig voneinander das folgende bedeuten :

m die Zahl 1 oder 2,

$R_1$ einen Rest

$-(CH_2)_x-$ , 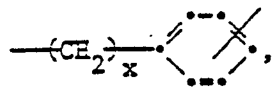, 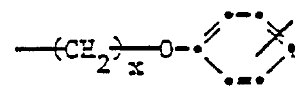 oder

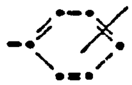,

wobei x eine Zahl von 1 bis 4 bedeutet,

$R_2$ einen carbocyclisch-aromatischen oder heterocyclischen Rest, wobei die Carbonamid- und Carboxylgruppen an verschiedenen Ringkohlenstoffatome gebunden sind und sich die Carboxylgruppen je in ortho-Stellung zu einer Carbonamidgruppe befinden,

$R_3$ einen carbocyclisch-aromatischen oder heterocyclischen Rest,

Q Methyl, Phenyl oder einen Rest —OY und

Y einen Alkylrest mit 1 bis 6 Kohlenstoffatomen oder einen Phenylrest auf Temperaturen zwischen 50 und 350 °C erhitzt.

2. Verwendung gemäss Anspruch 1, dadurch gekennzeichnet, dass die beschichtete Metallfolie eine Kupferfolie ist.

3. Verwendung gemäss Anspruch 1, dadurch gekennzeichnet, dass die Beschichtung aus einem vernetzten siloxangruppenhaltigen Polyamid, Polyimid oder Polyamid-imid besteht und erhalten wird, indem man siliciummodifizierte Präpolymere der Formel I, worin a für eine Zahl von 50 bis 100 steht und m, $R_1$, $R_2$, $R_3$, Q und Y die gleiche Bedeutung wie im Anspruch 1 haben auf Temperaturen zwischen 50 und 350 °C erhitzt.

4. Verwendung gemäss den Ansprüchen 1 oder 3, dadurch gekennzeichnet, dass die Beschichtung aus einen vernetzten siloxangruppenhaltigen Polyamid, Polyimid oder Polyamid-imid besteht und erhalten wird, indem man siliciummodifizierte Präpolymere der Formel I, worin die einzelnen $R_2$ unabhängig voneinander einen unsubstituierten monocyclischen, kondensierten polycyclischen oder unkondensierten bicyclischen aromatischen Rest darstellen, wobei bei letzterem die Aromatenkerne über das Brickenglied —O— oder —CO— miteinander verbunden sind, die einzelnen $R_3$ unabhängig voneinander einen unsubstituierten monocyclischen oder bicyclischen aromatischen Rest darstellen, wobei bei letzterem die Aromatenkerne über das Brückenglied —O—, $—CH_2—$, $—C(CH_3)_2—$, $—SO_2—$ oder durch eine direkte Bindung miteinander verbunden sind und m, $R_1$, Q und Y die gleiche Bedeutung wie im Anspruch 1 haben auf Temperaturen zwischen 50° und 350 °C erhitzt.

5. Verwendung gemäss Ansprüchen 1 oder 3, dadurch gekennzeichnet, dass die Beschichtung aus einem Polyamid-imid besteht, und erhalten wird, indem man siliciummodifizierte Präpolymere der Formel I, worin m für die Zahl 2 steht, $R_2$ einen Benzolring oder das Benzophenonringsystem und $R_3$ den 4,4'-Diphenyläther- oder 4,4'-Diphenylmethanrest darstellen und $R_1$, Q und Y die gleiche Bedeutung wie im Anspruch 1 haben, auf Temperaturen zwischen 50 und 350 °C erhitzt.

6. Verwendung gemäss Anspruch 1, dadurch gekennzeichnet, dass man zur Beschichtung eine mit einer wasserabsorbierenden Substanz stabilisierte organische Lösung eines siliciummodifizierten Polyamid-, Polyamidsäure- oder Polyamid-amidsäure-Präpolymeren verwendet.

7. Verwendung gemäss Anspruch 1, dadurch gekennzeichnet, dass man zur Beschichtung eine organische Lösung eines siliciummodifizierten Polyamid-, Polyamidsäure- oder Polyamid-amidsäure-Präpolymeren verwendet, welche zusätzlich ein Fliessmittel enthält.

## Claims

1. Use of a flexible base material for the production of flexible printed circuits, said base material consisting of a metal foil coated with a polymer without an intermediate layer, wherein the polymer coating consists of a crosslinked polyamide, polyimide or polyamide-imide which contains siloxane groups, the silicon content being 0.1 to 2.0 % by weight, and is obtained by heating a silicon-modified polyamide prepolymer, polyamide-acid prepolymer or polyamide-amidoacid prepolymer, of intrinsic viscosity from 0.3 to 4.0, of the formula I

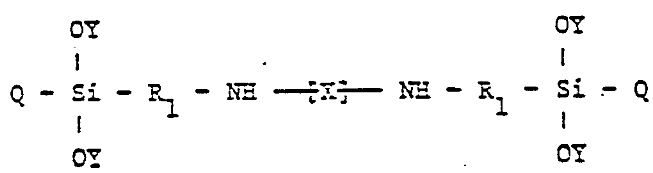 (I)

wherein X is a structural unit of the formula II

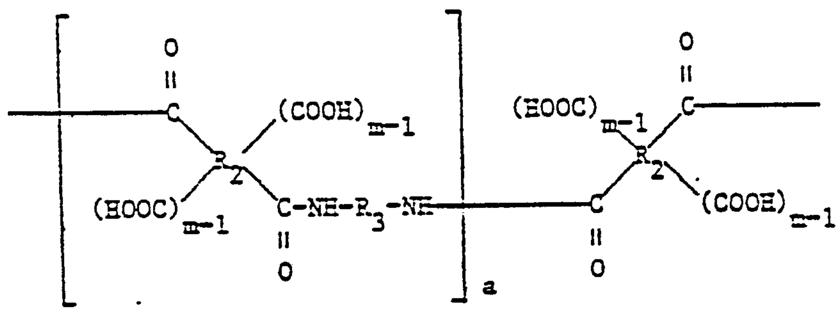

(II)

a is a number from 15 to 100 and the individual symbols m, $R_1$, $R_2$, $R_3$, Q and Y, independently of one another, are defined as follows :
m is 1 or 2,
$R_1$ is a

$-(CH_2)_x-$ , 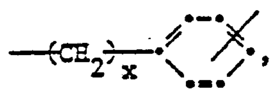, 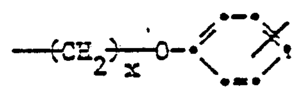 or

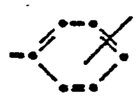 ,

radical, where x is a number from 1 to 4,

$R_2$ is a carbocyclic-aromatic or heterocyclic radical, in which the carbamoyl groups and carboxyl groups are attached to different ring carbon atoms and the carboxyl groups are each in the ortho-position to a carbamoyl group,

$R_3$ is a carbocyclic-aromatic or heterocyclic radical,

Q is methyl, phenyl or a radical —OY, and

Y is an alkyl radical of 1 to 6 carbon atoms or a phenyl radical,

in the temperature range from 50° to 350 °C.

2. Use of a base material according to claim 1, wherein the coated metal foil is a copper foil.

3. Use of a base material according to claim 1, wherein the coating consists of a crosslinked polyamide, polyimide or polyamide-imide containing siloxane groups and is obtained by heating a silicon-modified prepolymer of the formula I, wherein a is a number from 50 to 100 and m, $R_1$, $R_2$, $R_3$, Q and Y are as defined in claim 1, in the temperature range from 50° to 350 °C.

4. Use of a base material according to either of claims 1 or 3, wherein the coating consists of a crosslinked polyamide, polyimide or polyamide-imide which contains siloxane groups and is obtained by heating a silicon-modified prepolymer of the formula I, wherein each of the individual radicals $R_2$ independently is an unsubstituted monocyclic, fused polycyclic, or non-fused bicyclic aromatic radical, the aromatic nuclei in said last-mentioned radical being linked by the bridge member —O— or —CO—, each of the individual radicals $R_3$ is independently an unsubstituted monocyclic or bicyclic aromatic radical, the aromatic nuclei in the last-mentioned radical being linked by a bridge member —O—, $—CH_2—$, $—C(CH_3)_2—$ or $—SO_2—$ or by a direct bond, and m, $R_1$, Q and Y are as defined in claim 1, in the temperature range from 50° to 350 °C.

5. Use of a base material according to either of claims 1 or 3, wherein the coating consists of a polyamide-imide and is obtained by heating a silicon-modified prepolymer of the formula I, in which m is 2, $R_2$ is a benzene ring or the benzophenone ring system and $R_3$ is a 4,4'-diphenyl ether or 4,4'-diphenylmethane radical, and $R_1$, Q and Y are as defined in claim 1, in the temperature range from 50° to 350 °C.

6. Use according to claim 6, wherein an organic solution of a silicon-modified polyamide prepolymer, a polyamic acid prepolymer or polyamide-amic acid prepolymer, which organic solution is stabilised with a water-absorbing substance, is used for coating.

7. Use according to claim 1, wherein an organic solution of a silicon-modified polyamide prepolymer, polyamic acid prepolymer or polyamide-amic acid prepolymer, which solution additionally contains a flow control agent, is used for coating.

**Revendications**

1. Application d'un matériau de base souple à la fabrication de circuits imprimés souples, le matériau

de base étant constitué d'une feuille métallique revêtue, sans couche intermédiaire, d'un polymère, application caractérisée en ce que le revêtement en polymère est constitué d'un polyamide, polyimide ou polyamide-imide réticulé, contenant des radicaux siloxaniques et ayant une teneur en silicium comprise entre 0,1 et 2,0 % en poids et a été obtenu par chauffage, à des températures comprises entre 50 et 350 °C, d'un polyamide, polyamide-acide ou polyamide-amide-acide prépolymère modifié par du silicium, qui a une viscosité inhérente de 0,3 à 4,0 et qui répond à la formule I :

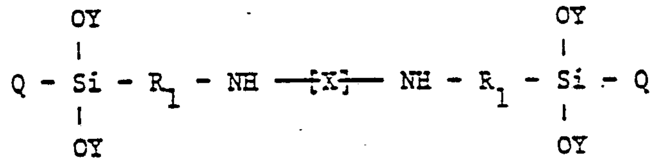

(I)

dans laquelle X représente une unité structurale répondant à la formule II :

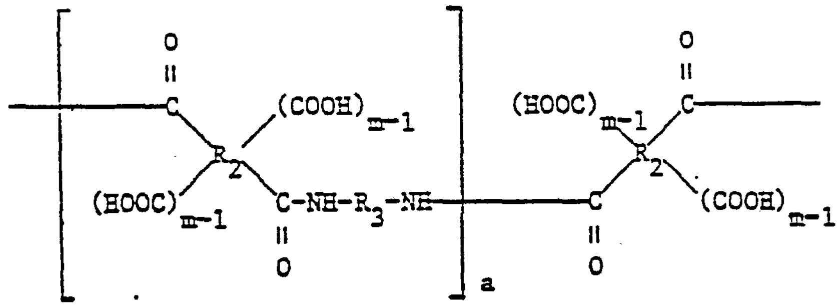

(II)

a représente un nombre de 15 à 100 et

les divers symboles m, $R_1$, $R_2$, $R_3$, Q et Y ont chacun, indépendamment les uns des autres, les significations suivantes :

m représente le nombre 1 ou le nombre 2,

$R_1$ représente un radical

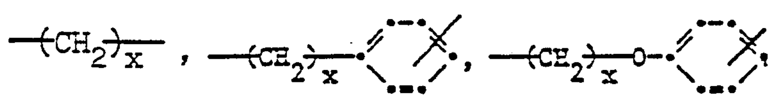 ou

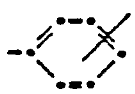 ,

le symbole x désignant un nombre de 1 à 4,

$R_2$ représente un radical carbocyclique-aromatique ou hétérocyclique qui porte les radicaux carbamoyles et carboxy sur des atomes de carbone cycliques différents et sur lequel les radicaux carboxy se trouvent chacun en une position ortho par rapport à un radical carbamoyle,

$R_3$ représente un radical carbocyclique-aromatique ou hétérocyclique,

Q représente un radical méthyle, phényle ou —OY et

Y représente un radical alkyle contenant de 1 à 6 atomes de carbone ou un radical phényle.

2. Application selon la revendication 1 caractérisée en ce que la feuille métallique revêtue est une feuille en cuivre.

3. Application selon la revendication 1 caractérisée en ce que le revêtement est constitué d'un polyamide, polyimide ou polyamide-imide à radicaux siloxaniques, réticulé, et a été obtenu par chauffage, à des températures comprises entre 50 et 350 °C, de prépolymères modifiés par du silicium qui répondent à la formule I dans laquelle a désigne un nombre de 50 à 100 et m, $R_1$, $R_2$, $R_3$, Q et Y ont les mêmes significations que dans la revendication 1.

4. Application selon l'une des revendications 1 et 3, caractérisée en ce que le revêtement est constitué d'un polyamide, polyimide ou polyamide-imide à radicaux siloxaniques, réticulé, et a été obtenu par chauffage, à des températures comprises entre 50 et 350 °C, de prépolymères modifiés par du silicium qui répondent à la formule I dans laquelle les divers symboles $R_2$ représentent chacun, indépendamment les uns des autres, un radical aromatique monocyclique non substitué, polycyclique condensé ou bicyclique non condensé, les noyaux aromatiques, dans ce dernier cas, étant reliés l'un à l'autre par un pont —O— ou —CO—, les divers symboles $R_3$ représentent chacun, indépendamment les uns des autres, un radical aromatique monocyclique ou bicyclique non substitué, les noyaux aromatiques, dans ce dernier cas, étant reliés l'un à l'autre par une liaison directe ou par un pont —O—, —$CH_2$—,

—$C(CH_3)_2$— ou —$SO_2$— et m, $R_1$, Q et Y ont les mêmes significations que dans la revendication 1.

5. Application selon l'une des revendications 1 et 3, caractérisée en ce que le revêtement est constitué d'un polyamide-imide et a été obtenu par chauffage, à des températures comprises entre 50 et 350 °C, de prépolymères modifiés par du silicium qui répondent à la formule I dans laquelle m est égal à 2, $R_2$ représente un noyau benzénique ou le système cyclique de la benzophénone, $R_3$ représente le radical phénoxybenzène-4,4' ou diphénylméthane-4,4', et $R_1$, Q et Y ont les mêmes significations que dans la revendication 1.

6. Application selon la revendication 1 caractérisée en ce qu'on utilise, pour l'enduction, une solution organique, stabilisée par une substance absorbant l'eau, d'un polyamide, polyamide-acide ou polyamide-amide-acide prépolymère modifié par du silicium.

7. Application selon la revendication 1 caractérisée en ce qu'on utilise, pour l'enduction, une solution organique d'un polyamide, polyamide-acide ou polyamide-amide-acide prépolymère, modifié par du silicium, qui contient en outre un agent d'écoulement.